# EUROPÄISCHE PATENTSCHRIFT

(11) **EP 0 979 800 B1**
(45) Veröffentlichungstag und Bekanntmachung des Hinweises auf die Patenterteilung: **14.05.2003**
(21) Anmeldenummer: 99113471.9
(22) Anmeldetag: 13.07.1999
(51) Int. Cl.: C01C 1/02, C01B 7/01, C01B 7/19, C01B 15/01, H01L 21/00, H01L 21/306

(54) **Erzeugung von gebrauchsfertigen Lösungen**
Manufacturing of ready-for-use solutions
Préparation de solution prête à l'usage

(30) Priorität: 14.08.1998 DE 19837041
(43) Veröffentlichungstag der Anmeldung: 16.02.2000
(73) Patentinhaber: Messer Griesheim GmbH, 65933 Frankfurt am Main (DE)
(72) Erfinder: Eschwey, Manfred, Dr., 40489 Düsseldorf (DE); Mainka, Gerd, 46242 Bottrop (DE); Hub, Dr. Walter, 81476 München (DE)

(56) Entgegenhaltungen:
- EP-A- 0 846 654
- EP-A- 0 915 060
- PATENT ABSTRACTS OF JAPAN vol. 009, no. 317 (C-319), 12. Dezember 1985 (1985-12-12) & JP 60 153922 A (HISAO KOJIMA), 13. August 1985 (1985-08-13)
- CHEMICAL ABSTRACTS, vol. 115, no. 11, 1991 Columbus, Ohio, US; abstract no. 113605n, ZSIGA, LASZLO; NAGY, JOZSEF: "Manufacture of ammonium hydroxide from liquid ammonia" XP000250756 & HU 54 943 A29. April 1991 (1991-04-29)

## Beschreibung

Die Erfindung betrifft ein Verfahren zur Herstellung von gebrauchsfertigen Lösungen durch Gasdirekteinleitung.

Die konventionelle Versorgung eines Halbleiterwerks mit Chemikalien erfolgt derzeit über die Belieferung von mehr oder weniger konzentrierten Chemikalien, in der Hauptsache konz. Salzssäure 36%, konz. Ammoniakwasser 28% und konz. Flußsäure 40%, via Tankwagen oder anderen geeigneten Gebinden (bis 20 m³). Sie dienen in der Regel zur Herstellung von Reinigungslösungen wie SC1 oder SC2 (SC = standard clean). Sie werden eingesetzt zur Entfernung partikullärer, organischer und metallischer Kontaminationen, die sich im Verlauf der Prozessierung auf der Waferoberfläche anreichern. Die Verteilung dieser Chemikalien zu den einzelnen Arbeitsplätzen ("Wet benches") erfolgt über ein zentrales Chemikalienversorgungssystem. Diese Art der Versorgung erfordert den Einsatz einer Vielzahl von teuren Chemikaliencontainern, verbunden mit einem hohen Aufwand für Installation, Wartung und Qualitätssicherungsmaßnahmen beim Halbleiterhersteller und dessen Lieferanten etc., da die geforderten Spezifikationswerte (Anionen, Kationen, organische Verunreinigungen) sich im unteren ppb Bereich bewegen.
Um diese Probleme zu lösen ist man in jüngster Zeit dazu übergegangen die konzentrierten Chemikalien für die Waferreinigung vor Ort zu erzeugen. Das heißt aus den entsprechenden gasförmigen Anhydriden und hochreinem Wasser wird die entsprechende konzentrierte Lösung durch Mischung in geeigneten verfahrenstechnischen Apparaten, in der Regel Rieselsäulen mit den entsprechenden Nebenaggregaten, wie Pumpen, Wärmetauscher etc., direkt erzeugt.
Eine solche Anlage zur Erzeugung von konzentrierten Lösungen wird in der Firmenbroschüre "Turnkey Chemical Distribution System" der Firma L' Air Liquide (verteilt auf der Semicon '98) beschrieben.

Die übliche Technik beinhaltet eine Reihe von Nachteilen:
- Die erzeugten konzentrierten Lösungen sind hochkorrosiv und demzufolge hoch kontaminationsanfällig.
- Die bei der Lösung von Ammoniak, Chlorwasserstoff oder Fluorwasserstoff in Wasser freigesetzten Wärmemengen müssen abgeführt werden.
- Zur Erreichung des Sättigungsendpunktes ist in der Regel eine mehrstufige Absorbtion und Kühlung notwendig.
- Zum Erzielen der erforderlichen Reinheiten müssen hochreine Gase eingesetzt bzw. technische Qualitäten nachgereinigt werden.

In der EP 0 915 060 A1 wird eine Vorrichtung zur Herstellung von ozonisiertem ultrareinem Wasser beschrieben, wobei ein ozonhaltiges Gas in einem Generator erzeugt und hochreinem Wasser zugemischt wird.

In der EP 0 846 654 A1 wird die on-site Herstellung ultrahochreinen Wasserstoffperoxidlösungen durch Einsatz von Ionenaustauschern beschrieben.

Der Erfindung liegt die Aufgabe zugrunde, ein Verfahren zur Herstellung von Reinigungslösungen für die Halbleiterherstellung bereitzustellen, das die genannten Nachteile vermeidet.

Es wurde gefunden, daß sich obengenannte Nachteile in einfacher und eleganter Weise überwinden lassen, wenn man die in der Halbleiterindustrie erforderlichen verdünnten Reinigungslösungen mit Hilfe eines korrosionsbeständigen statischen Mischersystems (z. B. Kanäle mit Einbauten, Zweistoffdüsen oder Injektormischer) vor Ort (am Ort der Verwendung), das heißt kurz vor Eintritt in das Prozeßbecken, aus entsprechenden gasförmigen Anhydriden durch Mischung mit Wasserstoffperoxid und Wasser direkt erzeugt.

Gegenstand der Erfindung ist somit ein Verfahren zur direkten Herstellung von Reinigungslösungen für die Halbleiterherstellung, dadurch gekennzeichnet, daß die Reinigungslösungen durch Mischen eines Gases das ans einem Druckgasbehälter bereitgestellt wird mit hochreinem Wasser oder hochreinem wäßrigen Lösungen direkt am Ort der Verwendung erzeugt werden, wobei ein statisches Mischersystem eingesetzt wird.

Reinigungslösungen werden durch Einleiten eines Gases, vorzugsweise eines der Gase NH₃, HCI oder HF, in Wasser oder wäßrige Lösungen erzeugt. NH₃, HCI und HF werden in der Regel als komprimierte Gas in Druckgasbehältern wie Druckgasflaschen bereitgestellt. Die Gase können auch als Gasgemisch, z. B. mit einem Inertgas wie Stickstoff, bereitgestellt werden, beispielsweise Fluorwasserstoff (HF) in Stickstoff. Die Druckgasbehälter mit den Gasen oder Gasgemischen dienen als Gasquelle. Die Gase werden vorzugsweise in hochreiner Form, insbesondere partikelfrei, eingesetzt.

Reinigungslösungen auf Basis wäßriger Ammoniaklösungen (NH₃ bzw. NH₄OH), die in der Regel Wasserstoffperoxid (H₂O₂) enthalten, werden im folgenden als SC1 (SC = standard clean) bezeichnet. Reinigungslösungen auf Basis wäßriger Salzsäurelösungen (HCI), die in der Regel Wasserstoffperoxid (H₂O₂) enthalten, werden im folgenden als SC2 (SC = standard clean) bezeichnet.

Bei dem Verfahren gemäß der Erfindung umgeht man die hochkonzentrierten, hochreaktiven Zwischenstufen und gelangt direkt zu Lösungen, die im Falle von SC1 max. 7 Gew.-% NH₃ und im Falle von SC2 max. 6 Gew.-% HCI enthalten.
SC1 ist beispielsweise eine Lösung NH₄OH / H₂O₂ / H₂O, 1:1:5 (v/v/v). SC2 ist beispielsweise eine Lösung HCI / H₂O₂ / H₂O, 1:1:5 (v/v/v). Zur Reinigung von Siliziumwafern wird beispielsweise in einem ersten Reinigungsschritt mit Reinigungslösung SC1 bei 70 °C behandelt, dann nach Entfernung von SC1 mit Wasser gespült, in einem zweiten Reinigungsschritt mit Reinigungslösung SC2 bei 70 °C behandelt und dann nach Entfernung von SC2 mit Wasser gespült.

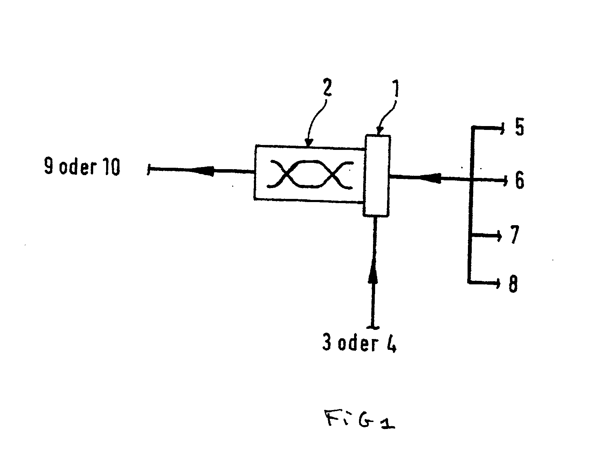

Wasserstoffperoxid (H₂O₂) wird eingesetzt zur Oxidation organischer Verunreinigungen. Wasserstoffperoxid kann unter bestimmten Bedingungen in den Lösungen durch Ozon (O₃) ersetzt oder in Kombination mit Ozon eingesetzt werden. Ozon wird in der Regel vor Ort mit einem Ozongenerator hergestellt, der als Ozon-Quelle dient. Ein prinzipielles Schema dieser Vorgehensweise ist in Fig. 1 dargestellt. Fig. 1 zeigt eine schematische Darstellung einer Vorrichtung zur Durchführung des erfindungsgemäßen Verfahrens zur Herstellung von Reinigungslösung wie SC1 oder SC2. NH₃-Gas aus einer NH₃-Gas-Quelle 3 (im Fall der Herstellung von SC1) oder HCI-Gas aus einer HCl-Gas-Quelle 4 (im Fall der Herstellung von SC2), Kaltwasser 5, Warm- oder Heißwasser 6, Wasserstoffperoxidlösung aus Wasserstoffperoxid-Quelle 7 und/oder Ozon aus Ozonquelle 7 (optional; statt Wasserstoffperoxid oder kombiniert mit Wasserstoffperoxid) werden in eine Einlaßkammer 1 eindosiert. Das entstandene rohe Gemisch wird von der Einlaßkammer 1 in die Mischkammer 2 geleitet, die vorzugsweise einen statischen Mischer enthält. In der Mischkammer 2 wird das Gemisch homogenisiert. Das fertige Gemisch, das ist die fertige Reinigungslösung (z. B. SC1 oder SC2), wird am Auslaß 9 (im Fall der Herstellung von SC1) oder Auslaß 10 (im Fall der Herstellung von SC2) entnommen und dem Reinigungsprozeß zugeführt.

Entscheidend für Darstellung einer reproduzierbaren, hochreinen wäßrigen Ammoniak- oder Salzäurelösung zur Reinigung von Siliziumwafern ist die Verwendung einer korrosionsbeständigen Mischeinrichtung in Verbindung mit einem ebenfalls korrosionsbeständigen Versorgungssystem für die benötigten Medien. Als geeignete Werkstoffe haben sich die in Tabelle 1 aufgeführten Materialien herausgestellt.

| **SC1:** | **SC2:** |
|---|---|
| **Polymerwerkstoffe** | |
| Polytetrafluorethylen (PTFE) | Polytetrafluorethylen (PTFE) |
| modifiziertes PTFE (TFM) | |
| Perfluoralkoxypolytetraethylen (PFA) | Perfluoralkoxypolytetraethylen (PFA) |
| Polytrifluorchlorethylen (PCTFE) | Polytrifluorchlorethylen (PCTFE) |
| Tetrafluorethylen-Ethylen- | Polyvinychlorid (PVC) |
| Mischpolymerisate (ETFE) | Polypropylen (PP) |
| Polyvinyldifluorid (PVDF) | Polyphenylensulfid (PPS) |
| Polypropylen (PP) | Polyethylen (PE) |
| Polyethylen (PE) | |
| Polyetheretherketon (PEEK) | |
| Polysulfone | |
| Polyamide | |

| **Metallische Werkstoffe** | |
|---|---|
| Aluminium | Tantal |
| Titan | Chrom/Nickelbasislegierungen |

Überraschenderweise erwies sich PVDF, der Standardwerkstoff für den Ultra clean-Bereich, unter Langzeitaspekten als völlig ungeeinget für die Erzeugung von SC1 (wegen Abbaureaktionen).

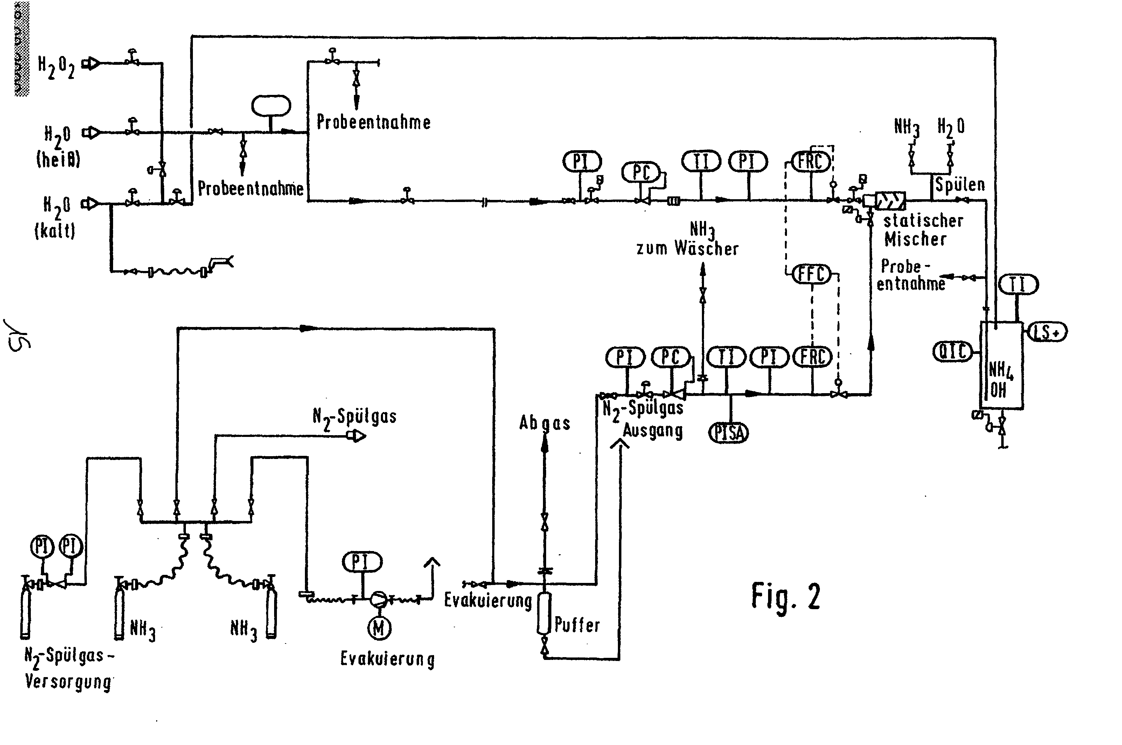

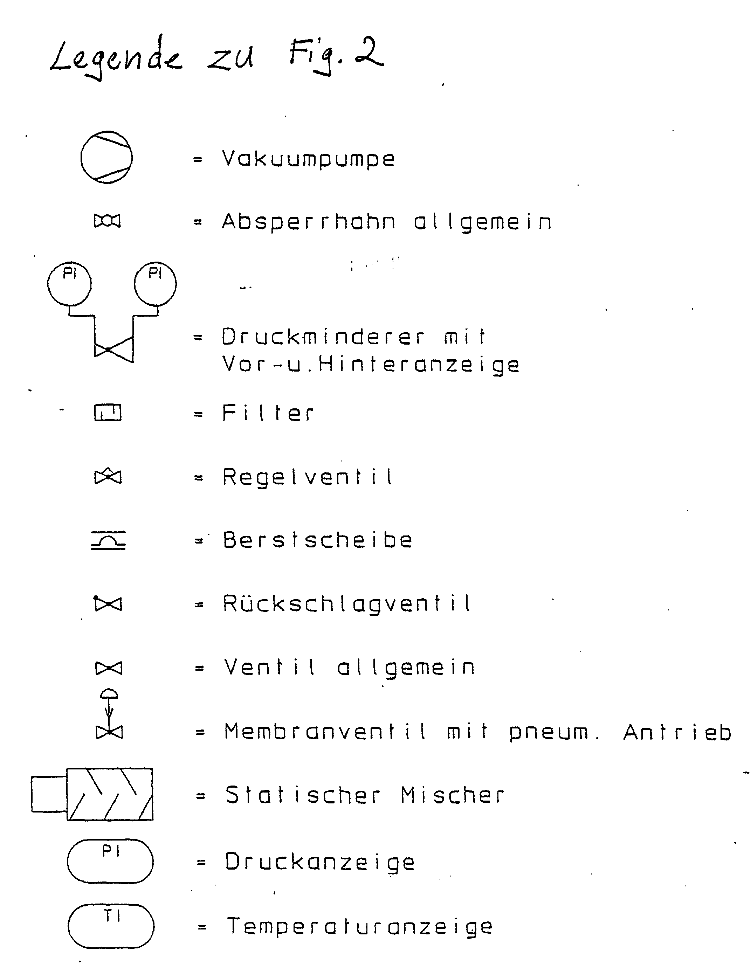

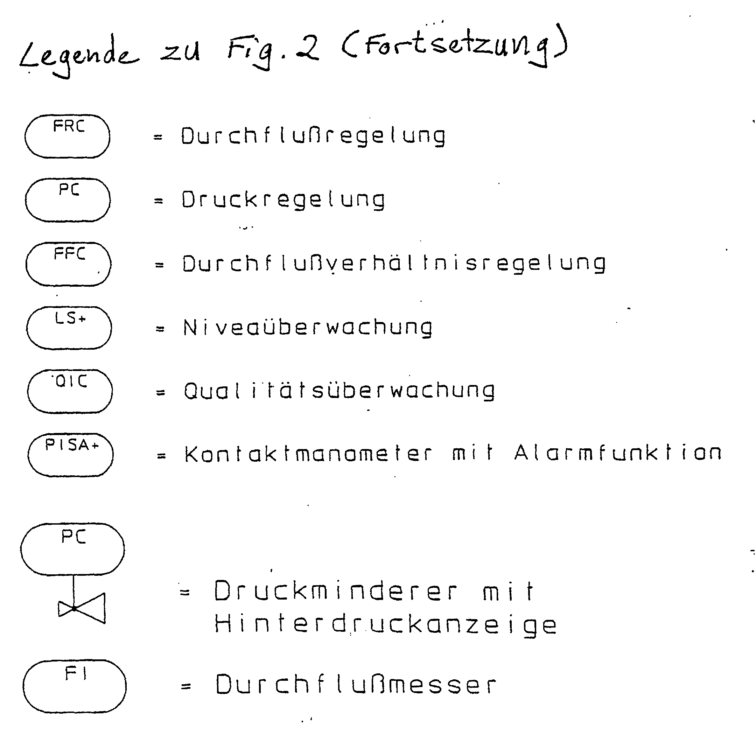

Die Leistungsfähigkeit des Verfahrens wurde an einer Testanlage mit einer Mischstrecke, bestehend aus einem statischen Mischer und den entsprechenden Meß- und Regelorganenen aus in Tabelle 1 aufgeführten Werkstoffen, geprüft. Der Aufbau der Testanlage ist aus dem in Fig. 2 gezeigten Schema ersichtlich.

Die Anlage erlaubt praktisch jedes Mischungsverhältnis aus NH₃, Wasserstoffperoxid und hochreinem Wasser reproduzierbar herzustellen (SC1). Die verwendeten Meß- und Regelaggregate entsprechen dem Stand der Technik und dienen zur exakten Mengenerfassung und zur Temperierung der Gas- und Flüssigkeitsströme. Völlig analog, entsprechend den Werkstoffempfehlungen in Tabelle 1, ist die Anlage für SC2 aufgebaut Die so erhaltenen Lösungen wurden mittels eines Massenspektrometers analysiert, dessen Einlaß mit einem induktiv angeregten Plasmabrenner verbunden ist. Dieses sogenannte ICP-MS System erlaubt Nachweisgrenzen, die für die meisten Verunreinigungen sich um 100 ppt bewegen. Sie ist die Standardmethode zur Analyse von Metallen im Ultraspurenbereich. Die Ergebnisse sind in der folgenden Tabelle 2 zusammengefaßt.

**Tabelle 2**

| NH₃-Konzentration in Gew.-% | 0,34 | 0,33* | 2,27 | 2,31* | 3,94 | 3,89* |
|---|---|---|---|---|---|---|
| Element | Konzentration in ppb | | | | | |
| Cr | 0,0421 | 0,0543 | 0,0764 | 0,0984 | 0,1013 | 0,1285 |
| Mn | 0,0286 | 0,0321 | 0,0432 | 0,0594 | 0,0697 | 0,1855 |
| Fe | 0,4060 | 0,9764 | 1,0987 | 1,3422 | 1,2227 | 1,8466 |
| Ni | 0,0976 | 0,1743 | 0,1987 | 0,3567 | 0,2142 | 0,7406 |
| Cu | 0,1709 | 0,1763 | 0,2985 | 0,7639 | 0,3721 | 0,9823 |

| | | | | | | |
|---|---|---|---|---|---|---|
| *Vergleichsprobe: Hergestellt aus 28% NH₃ aq (Electronic grade) durch verdünnen mit hochreinem Wasser | | | | | | |

Bei der Interpretation dieser Ergebnisse ist zu beachten, daß die Abnahme der Konzentration nicht im linearen Zusammenhang steht mit der Verdünnung. Sie ist vielmehr unter Praxisbedingungen (Ultraspurenbereich!) in komplexer Weise abhängig von dynamischen Gleichgewichtszuständen in Folge der Bildung von Oberflächenadsorbaten. Jedoch ist unschwer zu erkennen, daß die Kontaminationsbelastung im Verlaufe der Erzeugung von SC1-Lösung via Gasdirekteinleitung im Vergleich zum bisher praktizierten Verfahren deutlich geringer ausfällt Zusammen mit den eingangs beschriebenen Nachteilen bei der Herstellung von Reinigungslösungen in einer Waferfab bietet dieses neue Verfahren durch die Reduzierung des Chemikalieneinsatzes eine Reihe von ökologischen und ökonomischen Vorteile für den Halbleiterhersteller.

### Bezugszeichenliste

- 1: Einlaßkammer
- 2: Mischkammer mit statischem Mischer
- 3: NH₃-Gas-Quelle
- 4: HCl-Gas-Quelle
- 5: Kaltwasser
- 6: Warm- oder Heißwasser
- 7: Wasserstoffperoxid-Quelle (z. B. 30-%ige Lösung)
- 8: Ozon-Quelle (z. B. Ozongenerator)
- 9: Auslaß von SC1
- 10: Auslaß von SC2

## Patentansprüche

1. Verfahren zur direkten Herstellung von Reinigungslösungen für die Halbleiterherstellung, **dadurch gekennzeichnet, daß** die Reinigungslösungen durch Mischen eines Gases, das aus einem Druckgasbehälter bereitgestellt wird, mit hochreinem Wasser oder hochreinen wäßrigen Lösungen direkt am Ort der Verwendung erzeugt werden, wobei ein statisches Mischersystem eingesetzt wird.

2. Verfahren nach Anspruch 1, **dadurch gekennzeichnet, daß** die Reinigungslösungen durch Zumischen mindestens eines der Gase NH₃, HCl, HF oder eines Gasgemisches hergestellt werden.

3. Verfahren nach Anspruch 1 oder 2, **dadurch gekennzeichnet, daß** die hergestellten Reinigungslösungen verdünnte gebrauchsfertige Lösungen sind.

4. Verfahren nach einem der Ansprüche 1 bis 3, **dadurch gekennzeichnet, daß** die Reinigungslösung eine Reinigungslösung auf Basis einer wäßrigen Ammoniaklösung oder auf Basis einer wäßrigen Salzsäurelösung ist.

5. Verfahren nach einem der Ansprüche 1 bis 4, **dadurch gekennzeichnet, daß** die hergestellten Reinigungslösungen Wasserstoffperoxid und/oder Ozon enthalten.

6. Verfahren nach einem der Ansprüche 1 bis 5, **dadurch gekennzeichnet, daß** die das statische Mischersystem aus mindestens einem korrosionsbeständigen Werkstoff besteht.

7. Verfahren nach einem der Ansprüche 1 bis 6, **dadurch gekennzeichnet, daß** die das statische Mischersystem und die mit dem Gas in Kontakt kommenden Teile oder deren Oberfläche aus einem der Werkstoffe Polytetrafluorethylen (PTFE), Perfluoralkoxypolytetraethylen (PFA), Polytrifluorchlorethylen (PCTFE), Tetrafluorethylen-Ethylen-Mischpolymerisate (ETFE), Polyvinylchlorid (PVC), Polypropylen (PP), Polyvinyldifluorid (PVDF), Polyphenylensulfid (PPS), Polyethylen (PE), Polyetheretherketon (PEEK), Polysulfone, Polyamide, Aluminium, Tantal, Titan oder einer Chrom/Nickelbasislegierung besteht.

8. Verwendung eines statischen Mischers für die Herstellung von gebrauchsfertigen Reinigungslösungen zum direkten Einsatz bei der Herstellung von Halbleiter-Bauteilen, wobei die Herstellung der Reinigungslösungen die Dosierung von mindestens einem Gas oder Gasgemisch in hochreinem Wasser oder eine hochreine wäßrige Lösung umfaßt und das Gas oder Gasgemisch aus einem Druckgasbehälter bereitgestellt wird.

9. Verwendung nach Anspruch 8, **dadurch gekennzeichnet, daß** das Gas oder Gasgemisch mindestens eines der Gase NH₃, HCI oder HF enthält.

## Claims

1. Process for direct production of cleaning solutions for semiconductor fabrication, **characterized in that** the cleaning solutions are produced by mixing a gas, which is provided from a compressed-gas vessel, with high-purity water or high-purity aqueous solutions directly at the location of use, a static mixer system being used.

2. Process according to Claim 1, **characterized in that** the cleaning solutions are produced by admixing at least one of the gases NH₃, HCl, HF or a gas mixture.

3. Process according to Claim 1 or 2, **characterized in that** the cleaning solutions produced are dilute ready-to-use solutions.

4. Process according to one of Claims 1 to 3,
**characterized in that** the cleaning solution is a cleaning solution based on an aqueous ammonia solution or based on an aqueous hydrochloric acid solution.

5. Process according to one of Claims 1 to 4, **characterized in that** the cleaning solutions produced contain hydrogen peroxide and/or ozone.

6. Process according to one of Claims 1 to 5, **characterized in that** the the [sic] static mixer system consists of at least one corrosion-resistant material

7. Process according to one of Claims 1 to 6, **characterized in that** the the [sic] static mixer system and those parts or the surface thereof which come into contact with the gas consists of one of the materials polytetrafluoroethylene (PTFE), perfluoro-alkoxy-polytetraethylene (PFA), polytrifluoro-chloroethylene (PCTFE), tetrafluoroethylene-ethylene copolymers (ETFE), polyvinyl chloride (PVC), polypropylene (PP), polyvinyl difluoride (PVDF), polyphenylene sulfide (PPS), polyethylene (PE), polyether ether ketone (PEEK), polysulfones, polyamides, aluminium, tantalum, titanium or a chromium/nickel-base alloy.

8. Use of a static mixer for production of ready-to-use cleaning solutions for direct use in the fabrication of semiconductor components, the production of the cleaning solutions comprising the step of metering at least one gas or gas mixture into high-purity water or a high-purity aqueous solution, and the gas or gas mixture being provided from a compressed-gas vessel.

9. Use according to Claim 8, **characterized in that** the gas or gas mixture contains at least one of the gases NH₃, HCl or HF.

## Revendications

1. Procédé de production directe de solutions de purification pour la fabrication de semi-conducteurs,
**caractérisé en ce que**
les solutions de purification sont produites par mélange d'un gaz disponible à partir d'un réservoir de gaz, avec de l'eau très pure ou des solutions aqueuses très pures à l'endroit de l'utilisation, pour lequel un système de mélangeur statique est mis en oeuvre.

2. Procédé selon la revendication 1,
**caractérisé en ce que**
les solutions de purification sont produites par addition par mélange d'au moins un des gaz NH₃, ClH, FH ou d'un mélange gazeux.

3. Procédé selon l'une quelconque des revendications 1 ou 2,
**caractérisé en ce que**
les solutions de purification préparées sont des solutions diluées prêtes à l'emploi.

4. Procédé selon l'une quelconque des revendications 1 à 3,
**caractérisé en ce que**
la solution de purification est une solution de purification à base d'une solution aqueuse d'ammoniac ou à base d'une solution aqueuse d'acide chlorhydrique.

5. Procédé selon l'une quelconque des revendications 1 à 4,
**caractérisé en ce que**
les solutions de purification préparées renferment du peroxyde d'hydrogène et/ou de l'ozone.

6. Procédé selon l'une quelconque des revendications 1 à 5,
**caractérisé en ce que**
les pièces qui contiennent le système de mélangeur statique consistent en au moins un matériau résistant à la corrosion.

7. Procédé selon l'une quelconque des revendications 1 à 6,
**caractérisé en ce que**
les pièces qui contiennent le système statique de mélangeur et les pièces qui viennent en contact avec le gaz ou leur surfaces, consistent en l'un des matériaux polytétrafluoroéthylène (PTFE), perfluoroalkoxypoly-tétraéthylène (PFA), polytrifluorochloroéthylène (PCTFE), polymérisats mixtes tétrafluoroéthylène-éthylène (ETFE), chlorure de polyvinyle (PVC), polypropylène (PP), difluorure de polyvinyle (PVDF), sulfure de polyphénylène (PPS). polyéthylène (PE), polyétherether cétone (PEEK), polysulfone, polyamide. aluminium, tantale, titane ou un mélange à base de chrome/nickel.

8. Utilisation d'un mélangeur statique pour la production de solutions de purification prêtes à l'emploi pour l'utilisation directe dans la fabrication d'éléments de construction de semi-conducteurs, dans laquelle la production des solutions de purification comprend l'admission dosée d'au moins un gaz ou un mélange de gaz, dans de l'eau très pure ou dans une solution aqueuse très pure, le gaz ou le mélange de gaz étant disponible à partir d'un réservoir de gaz sous pression.

9. Utilisation selon la revendication 8,
**caractérisée en ce que**
le gaz ou le mélange de gaz renferme au moins un des gaz NH₃, ClH ou FH.
